# EUROPEAN PATENT SPECIFICATION

(11) **EP 4 622 050 B1**
(45) Date of publication and mention of the grant of the patent: **19.08.2026**
(21) Application number: 25162677.6
(22) Date of filing: 10.03.2025
(51) Int. Cl.: H02J 7/40, H02J 7/50, H04L 12/40

(54) **ENERGY STORAGE DEVICE AND ENERGY STORAGE SYSTEM**
ENERGIESPEICHERVORRICHTUNG UND ENERGIESPEICHERSYSTEM
DISPOSITIF DE STOCKAGE D'ÉNERGIE ET SYSTÈME DE STOCKAGE D'ÉNERGIE

(30) Priority: 18.03.2024 CN 202410306573
(43) Date of publication of application: 24.09.2025
(73) Proprietor: Solax Power Network Technology (Zhejiang) Co., Ltd., Hangzhou, Zhejiang 311500 (CN)
(72) Inventor: YANG, Xingxing, 311500 Hangzhou (CN); SONG, Su, 311500 Hangzhou (CN); GU, Tao, 311500 Hangzhou (CN)
(74) Representative: Novagraaf International SA

(56) References cited:
- CN-A- 106 302 063
- CN-U- 218 413 270
- US-A1- 2021 382 843

## Description

### TECHNICAL FIELD

The present application relates to the field of power electronics technologies, and in particular, to an energy storage device and an energy storage system.

### BACKGROUND

Currently, power provided by a single energy storage device cannot no longer meet a power demand in some scenarios. In this case, a plurality of energy storage devices are required to be connected to a controller area network (controller area network, CAN) bus, to form an energy storage system to meet the power demand in these scenarios. In an existing energy storage system, a quantity of terminal resistors on a CAN bus is required to be manually detected, and a terminal resistor is required to be manually connected, so as to implement configuration of the terminal resistor on the CAN bus, which is very cumbersome to operate and results in a waste of manpower and material resources.

Patent application document No. CN106302063A provides a CAN communication bus circuit system and a method for controlling connection of termination resistors, aiming to solve the problems in the prior art where manual detection is required to determine whether termination resistors are present at both ends of the CAN communication bus, hardware-circuit designs must take into account DIP switches for connecting or disconnecting these resistors, and subsequent maintenance consumes manpower, material resources and time. This method includes connecting, at every CAN node on the CAN communication bus, an impedance-adjusting device whose connection state is controllable, ensuring that at any given moment exactly two impedance-adjusting devices are in the connected state. The impedance-adjusting device includes a control module, a controllable switch module and a termination-resistor module.

Patent application document No. US2021382843A1 provides a bus-capable device with an input interface and an output interface for connection to a serial bus, in particular a CAN communication bus. Each interface has at least one signal-line connection. The device further includes a terminating resistor for bus termination and a switching arrangement that activates this resistor in dependence on the connection status of the two interfaces. Each interface also carries a supply-voltage connection, used to deliver supply voltage to the corresponding interface of the next bus-capable device, and a feedback connection that receives supply voltage from that next device. The switching arrangement contains an evaluation circuit which detects whether supply voltage is present on the feedback connections of both interfaces, and an activation circuit that turns the terminating resistor on when the evaluation circuit finds supply voltage absent from the feedback connection of the input interface and/or the output interface.

Patent application document No. CN218413270U provides a CAN communication bus system and a vehicle. The CAN communication bus system includes: a CAN communication bus, a CAN terminal resistor, a voltage detection circuit, a judgment control circuit, and a first switching device. The CAN communication bus includes a CAN_H line and a CAN_L line. The CAN terminal resistor includes a node resistor and a configurable resistor. A first end of the configurable resistor is connected to the CAN_H line, and a second end thereof is connected to the CAN_L line via the first switching device. The voltage detection circuit includes a voltage acquisition device and, sequentially connected, a voltage source, a second switching device, and a sampling resistor. The second switching device is electrically connected to the CAN_H line and the CAN_L line. A first end of the sampling resistor is connected to the second switching device, and a second end thereof is grounded. An input end of the voltage acquisition device is connected to the first end of the sampling resistor, and an output end thereof is connected to an input end of the judgment control circuit. An output end of the judgment control circuit is connected to the first switching device. This system can effectively improve the reliability of CAN communication bus.

### SUMMARY

In view of the foregoing problems, the present application provides an energy storage device and an energy storage system. The energy storage device and the energy storage system in the present application may solve problems in a conventional technology that a quantity of terminal resistors on a CAN bus is required to be manually detected and a terminal resistor on a CAN bus is required to be manually configured.

The invention is defined by the independent claim. Advantageous embodiments are provided by the dependent claims. According to a first aspect, an energy storage device according to claim 1 is provided.

According to a second aspect, the present application further provides an energy storage system according to claim 9. According to the present application, problems in a conventional technology that a quantity of terminal resistors on a CAN bus is required to be manually detected and a terminal resistor on a CAN bus is required to be manually configured may be solved.

### BRIEF DESCRIPTION OF THE DRAWINGS

FIG. 1 is a schematic diagram of an energy storage system according to an embodiment of the present application.
FIG. 2 is a schematic diagram of an energy storage device in an energy storage system according to an embodiment of the present application.
FIG. 3 is another schematic diagram of an energy storage device in an energy storage system according to an embodiment of the present application.
FIG. 4 is a circuit diagram of a controller in an energy storage device according to an embodiment of the present application.
FIG. 5 is a circuit diagram of an energy storage device according to an embodiment of the present application.

### DETAILED DESCRIPTION OF THE EMBODIMENTS

A CAN bus is a serial communications protocol bus used in a real-time control system. Due to its high performance, high reliability, and unique design, the CAN bus has received increasing attention and is widely used in many fields. For example, the CAN bus is widely used in an energy storage system.

Generally, power provided by a single energy storage device cannot no longer meet a power demand in some scenarios. In this case, a plurality of energy storage devices are required to be connected to a CAN bus, to form an energy storage system to meet the power demand in these scenarios. In an existing energy storage system, a quantity of terminal resistors on a CAN bus is required to be manually detected, and a terminal resistor is required to be manually connected, so as to implement configuration of the terminal resistor on the CAN bus, which is very cumbersome to operate and causes waste.

To solve the foregoing problems, embodiments of the present application provide an energy storage device and an energy storage system. Therefore, configuration of a terminal resistor on a communications bus may be implemented without manually determining a quantity of terminal resistors, or manually connecting the terminal resistor to the communications bus, so as to simplify the operation. This may solve problems such as a waste of manpower, material resources, and time; may save time and effort, and may solve technical problems in a conventional solution.

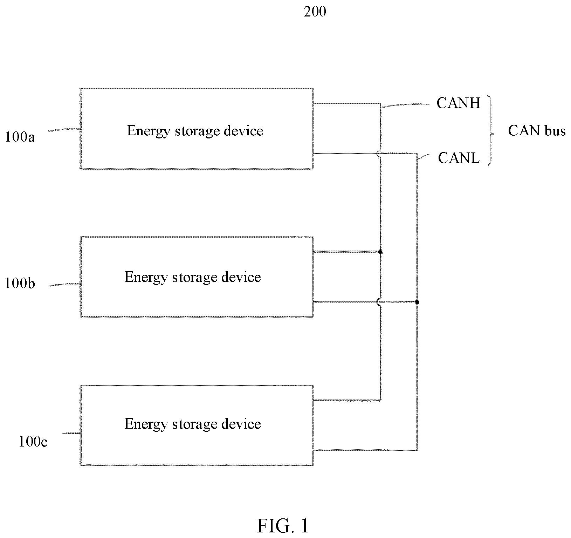

Referring to FIG. 1, FIG. 1 is a schematic diagram of an energy storage system 200 according to an embodiment of the present application.

The energy storage system 200 may include a plurality of energy storage devices, and each energy storage device may implement a communication connection via a communications bus. The communications bus may be a CAN bus.

As shown in FIG. 1, in this embodiment, only three energy storage devices 100a, 100b, and 100c are used as examples for description, and there may be more than three or less than three energy storage devices. It may be understood that the energy storage device 100a, the energy storage device 100b, and the energy storage device 100c implement a communication connection via a CAN bus. The CAN bus includes lines CANH and CANL.

In this embodiment, the energy storage device 100a is connected to the energy storage device 100b and the energy storage device 100c via a CANH signal line. The energy storage device 100a is further connected to the energy storage device 100b and the energy storage device 100c via a CANL signal line. In an example of the present application, the energy storage device 100a, the energy storage device 100b, and the energy storage device 100c each configure a 120-ohm terminal resistor.

It may be understood that a standard requirement of the CAN bus can be met only when there is only two 120-ohm resistors between the CANH signal line and the CANL signal line. Therefore, it is required to ensure that 120-ohm terminal resistors in only two energy storage devices are connected to the CAN bus in an operating state of the energy storage system 200.

For example, in an application scenario of an energy storage system, the energy storage device 100a, the energy storage device 100b, and the energy storage device 100c are respectively powered on at different time points, and the energy storage device 100a, the energy storage device 100b, and the energy storage device 100c may detect and configure a terminal resistor on the CAN bus.

If the energy storage device 100a detects that no terminal resistor exists on the CAN bus, that is, neither the terminal resistor of the energy storage device 100b nor the terminal resistor of the energy storage device 100c is connected to the CAN bus, the energy storage device 100a is required to connect the terminal resistor to the CAN bus. If the energy storage device 100a detects that there is one terminal resistor on the CAN bus, that is, one terminal resistor in the energy storage device 100b and the energy storage device 100c is connected to the CAN bus, the energy storage device 100a is required to connect the terminal resistor to the CAN bus. If the energy storage device 100a detects that there are two terminal resistors on the CAN bus, that is, the terminal resistor of the energy storage device 100b and the terminal resistor of the energy storage device 100c are both connected to the CAN bus, and two terminal resistors are connected to the CAN bus, the energy storage device 100a is not required to connect the terminal resistor to the CAN bus.

If the energy storage device 100b detects that no terminal resistor exists on the CAN bus, that is, neither the terminal resistor of the energy storage device 100a nor the terminal resistor of the energy storage device 100c is connected to the CAN bus, the energy storage device 100b is required to connect the terminal resistor to the CAN bus. If the energy storage device 100b detects that there is one terminal resistor on the CAN bus, that is, one terminal resistor in the energy storage device 100a and the energy storage device 100c is connected to the CAN bus, the energy storage device 100b is required to connect the terminal resistor to the CAN bus. If the energy storage device 100b detects that there are two terminal resistors on the CAN bus, that is, the terminal resistor of the energy storage device 100a and the terminal resistor of the energy storage device 100c are both connected to the CAN bus, and two terminal resistors are connected to the CAN bus, the energy storage device 100b is not required to connect the terminal resistor to the CAN bus.

If the energy storage device 100c detects that no terminal resistor exists on the CAN bus, that is, neither the terminal resistor of the energy storage device 100a nor the terminal resistor of the energy storage device 100b is connected to the CAN bus, the energy storage device 100c is required to connect the terminal resistor to the CAN bus. If the energy storage device 100c detects that there is one terminal resistor on the CAN bus, that is, one terminal resistor in the energy storage device 100a and the energy storage device 100b is connected to the CAN bus, the energy storage device 100c is required to connect the terminal resistor to the CAN bus. If the energy storage device 100c detects that there are two terminal resistors on the CAN bus, that is, the terminal resistor of the energy storage device 100a and the terminal resistor of the energy storage device 100b are both connected to the CAN bus, and two terminal resistors are connected to the CAN bus, the energy storage device 100c is not required to connect the terminal resistor to the CAN bus.

It may be understood that structures of the energy storage device 100a, the energy storage device 100b, and the energy storage device 100c are completely the same. The following uses a structure of the energy storage device 100a as an example for description.

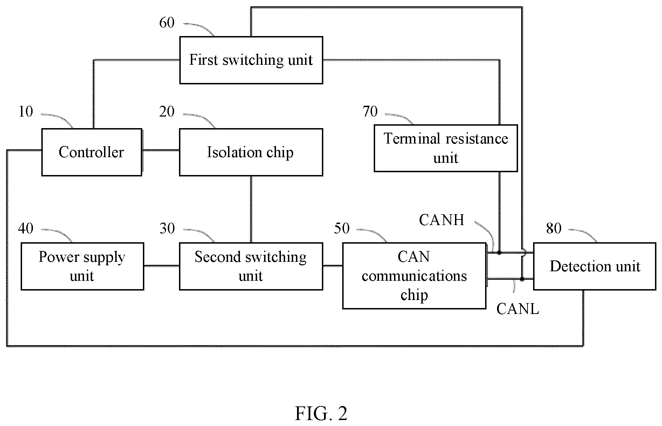

Referring to FIG. 2, FIG. 2 is a schematic diagram of an energy storage device 100a according to an embodiment of the present application.

The energy storage device 100a includes a controller 10, a second switching unit 30, a power supply unit 40, a CAN communications chip 50, a first switching unit 60, a terminal resistance unit 70, and a detection unit 80. It may be understood that the energy storage device 100a may further include another component. For example, the energy storage device 100a may further include a battery unit.

The controller 10 may be electrically connected to the second switching unit 30 and the detection unit 80. The second switching unit 30 is electrically connected between the power supply unit 40 and the CAN communications chip 50. The CAN communications chip 50 is communicatively connected to a CAN communications chip of another energy storage device (for example, the energy storage device 100b or the energy storage device 100c) via a CANH signal line or a CANL signal line. The detection unit 80 is connected to the CANH signal line and a CANL signal line. A first end of the terminal resistance unit 70 is electrically connected to the CANH signal line, a second end of the terminal resistance unit 70 is electrically connected to a first end of the first switching unit 60, and a second end of the first switching unit 60 is electrically connected to the CANL signal line.

In other words, the terminal resistance unit 70 and the first switching unit 60 are successively connected in series to two ends of a CAN bus. The detection unit 80 is connected to two ends of the CAN bus. It may be understood that the detection unit 80 may be configured to detect a terminal resistor on the CAN bus based on a first control signal from the controller 10, and the controller 10 may collect a detection signal from the detection unit 80, and determine, based on the detection signal, whether two ends of the CAN bus are required to be connected to or disconnected from the terminal resistance unit 70. For example, when the controller 10 determines, based on the detection signal of the detection unit 80, that the two ends of the CAN bus are required to be connected to the terminal resistance unit 70, the controller 10 controls the first switching unit 60 to be turned on. When the controller 10 determines, based on the detection signal from the detection unit 80, that the two ends of the CAN bus are required to be disconnected from the terminal resistance unit 70, the controller 10 controls the first switching unit 60 to be turned off.

It may also be understood that the controller 10 may be further configured to determine a resistance value of a terminal resistor on a communications bus in response to the detection signal from the detection unit 80. For example, the resistance value of the terminal resistor on the communications bus may be a resistance value of the terminal resistor on the CAN bus.

It may be understood that the two ends of the CAN bus mentioned in this specification may refer to the CANH signal line and the CANL signal line of the CAN bus. For example, the detection unit 80 being connected to the two ends of the CAN bus may refer to that the detection unit 80 is connected to any connection point on the CANH signal line and any connection point on the CANL signal line.

In this embodiment, the second switching unit 30 may receive the first control signal from the controller 10. The first control signal may be used for controlling the second switching unit 30 to enable the power supply unit 40 and the CAN communications chip 50 to be electrically connected or disconnected. It may be understood that, in an optional embodiment, the power supply unit 40 may be a battery unit in the energy storage device.

In an optional implementation, the energy storage device 100a may further include an isolation chip 20, and the isolation chip 20 is electrically connected to the controller 10 and the second switching unit 30. The controller 10 may be configured to output the first control signal to the isolation chip 20.

The isolation chip 20 may be configured to output a drive signal to the second switching unit 30 after performing isolation processing on the first control signal. The drive signal output by the isolation chip 20 may be used for controlling the second switching unit 30 to enable the power supply unit 40 and the CAN communications chip 50 to be electrically connected or disconnected.

In an optional implementation, the isolation chip 20 may be further electrically connected to the detection unit 80. The drive signal output by the isolation chip 20 may be further used for controlling the detection unit 80, to enable the detection unit 80 to detect a terminal resistor on a CAN bus.

The controller 10 is further configured to output a second control signal to the first switching unit 60. The first switching unit 60 enables the terminal resistance unit 70 and the CAN bus to be connected or disconnected based on the second control signal. In other words, when the second control signal controls the first switching unit 60 to be turned on, the terminal resistance unit 70 is connected to the CAN bus. When the second control signal controls the first switching unit 60 to be turned off, the terminal resistance unit 70 is disconnected from the CAN bus.

In this embodiment, the detection unit 80 is electrically connected to the controller 10. The controller 10 may acquire a detection signal from the detection unit 80, and output a corresponding second control signal to the first switching unit 60 based on the detection signal.

For example, when an energy storage system 200 detects the terminal resistor on the CAN bus, that is, the energy storage system 200 is in a terminal resistor detection mode, the controller 10 outputs a first control signal at a first level to the isolation chip 20, the isolation chip 20 performs isolation processing on the first control signal at the first level, and outputs a drive signal at the first level to the second switching unit 30 and the detection unit 80. The drive signal at the first level controls the second switching unit 30 to enable the power supply unit 40 and the CAN communications chip 50 to be disconnected. In other words, the power supply unit 40 does not supply power to the CAN communications chip 50, and the CAN communications chip 50 that does not receive power supply is in a high resistance state for the CAN bus, that is, the CAN communications chip 50 does not affect detection of the terminal resistor on the CAN bus. The drive signal at the first level further controls the detection unit 80 to detect the terminal resistor on the CAN bus. The controller 10 determines a quantity of the terminal resistors of the CAN bus based on the detection signal of the detection unit 80, and then outputs a corresponding second control signal to the first switching unit.

When the controller 10 determines, based on the detection signal, that there are two terminal resistors on the CAN bus, that is, the terminal resistor in the energy storage device 100a is not required to be connected to the CAN bus, the controller 10 outputs a second control signal at a second level to the first switching unit 60, to control the first switching unit 60 to be turned off. In this case, the terminal resistance unit 70 is disconnected from the CANH signal line and the CANL signal line, and the terminal resistance unit 70 is not connected to the CAN bus.

When the controller 10 determines, based on the detection signal, that there is one terminal resistor on the CAN bus or no terminal resistor on the CAN bus, that is, the terminal resistor in the energy storage device 100a is required to be connected to the CAN bus, the controller 10 outputs a second control signal at the first level to the first switching unit 60, to control the first switching unit 60 to be turned on. In this case, the terminal resistance unit 70 is connected to the CANH signal line and the CANL signal line, and the terminal resistance unit 70 is connected to the CAN bus.

When the energy storage system 200 does not detect the terminal resistor on the CAN bus, that is, the energy storage system 200 is in a normal communication mode, the controller 10 outputs a first control signal at the second level to the isolation chip 20, the isolation chip 20 performs isolation processing on the first control signal at the second level, and outputs a drive signal at the second level to the detection unit 80, so that the detection unit 80 does not detect the terminal resistor on the CAN bus. The drive signal at the second level is further output to the second switching unit 30, to control the second switching unit 30 to be turned on, so that the power supply unit 40 can supply power to the CAN communications chip 50. In this case, the CAN communications chip 50 communicates normally with a CAN communications chip of another energy storage device (for example, the energy storage device 100b and the energy storage device 100c) via a CAN bus.

Based on such a design, in embodiments of the present application, configuration of a terminal resistor on a communications bus may be implemented without manually determining a quantity of terminal resistors, or manually connecting the terminal resistor to the communications bus, so as to simplify the operation and save time and effort, so that technical problems in a conventional solution may be solved.

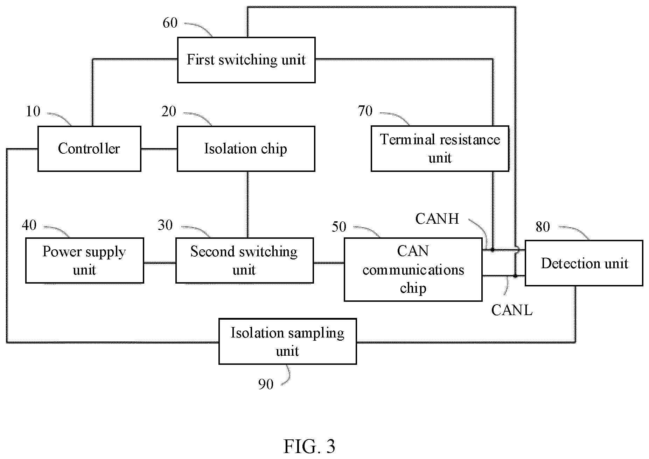

Referring to FIG. 3, FIG. 3 is a schematic diagram of an energy storage device 100a according to another embodiment of the present application.

A difference from the energy storage device 100a shown in the embodiment in FIG. 2 lies in that, as shown in FIG. 3, in this embodiment, the energy storage device 100a may further include an isolation sampling unit 90.

The isolation sampling unit 90 is electrically connected between the detection unit 80 and the controller 10.

In this embodiment, the isolation sampling unit 90 may perform isolation sampling on the detection signal of the detection unit 80, and transmit a detection signal obtained after the isolation sampling to the controller 10. The controller 10 may determine a quantity of terminal resistors on the CAN bus based on the detection signal obtained after the isolation sampling.

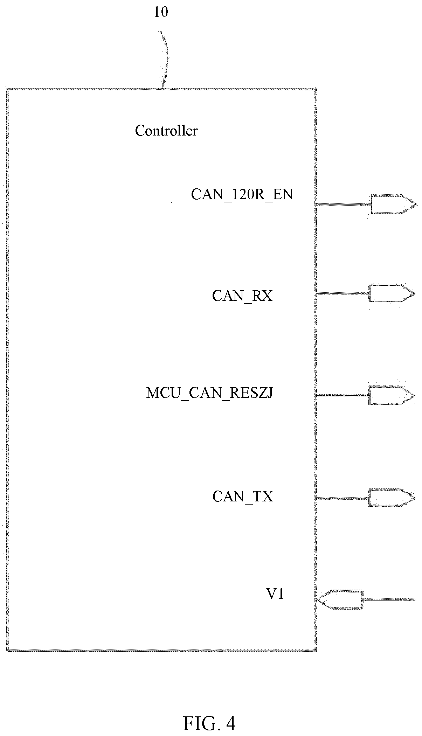

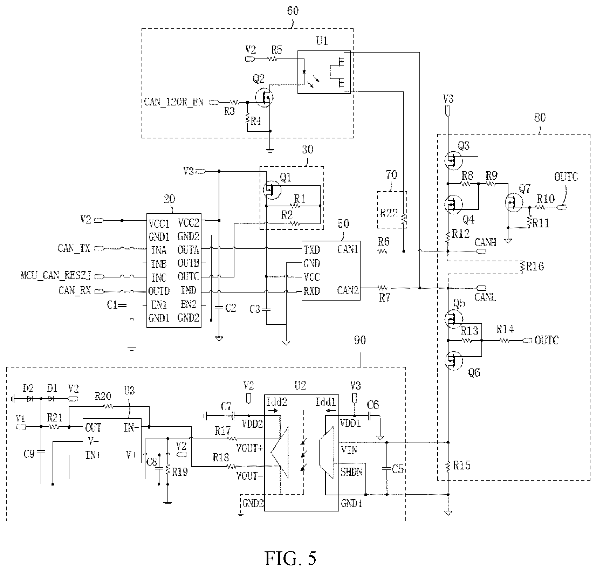

Referring to FIG. 4 and FIG. 5, FIG. 4 and FIG. 5 are schematic circuit diagrams of an energy storage device 100a according to an embodiment of the present application.

As shown in FIG. 4, a controller 10 in this embodiment may include a first signal pin MCU_CAN_RESZJ, a second signal pin CAN_120R_EN, a third signal pin V1, a receive pin CAN_RX, and a transmit pin CAN_TX. It may be understood that, in an optional implementation, the controller 10 may be a microcontroller unit (microcontroller unit, MCU).

As shown in FIG. 5, a power pin VCC1 of an isolation chip 20 is connected to a power supply unit 40, so as to receive a voltage V2 output by the power supply unit 40. The power pin VCC1 of the isolation chip 20 is further connected to a ground pin GND1 of the isolation chip 20 through a capacitor C1. A power pin VCC2 of the isolation chip 20 is connected to the power supply unit 40, so as to receive a voltage V3 output by the power supply unit 40. The power pin VCC2 of the isolation chip 20 is further grounded through a capacitor C2. Both the ground pin GND1 and the ground pin GND2 of the isolation chip 20 are grounded, and a signal pin INA of the isolation chip 20 is electrically connected to the transmit pin CAN_TX of the controller 10. A signal pin INC of the isolation chip 20 is electrically connected to the first signal pin MCU_CAN_RESZJ of the controller 10, so as to receive a first control signal output by the first signal pin MCU_CAN_RESZJ of the controller 10. A signal pin OUTD of the isolation chip 20 is electrically connected to the receive pin CAN_RX of the controller 10. The signal pin OUTA of the isolation chip 20 is electrically connected to a signal pin TXD of a CAN communications chip 50, the signal pin OUTC of the isolation chip 20 is electrically connected to a second switching unit 30, and a signal pin IND of the isolation chip 20 is electrically connected to a signal pin RXD of the CAN communications chip 50. A ground pin GND of the CAN communications chip 50 is grounded. A first communication pin CAN1 of the CAN communications chip 50 is electrically connected to a CANH signal line through a resistor R6, and a second communication pin CAN2 of the CAN communications chip 50 is electrically connected to a CANL signal line through a resistor R7.

In this embodiment, the second switching unit 30 includes a switch transistor Q1, a resistor R1, and a resistor R2. A first end of the switch transistor Q1 is electrically connected to the signal pin OUTC of the isolation chip 20 through the resistor R2, so as to receive a drive signal output by the signal pin OUTC of the isolation chip 20. A second end of the switch transistor Q1 is electrically connected to the power supply unit 40, so as to receive a voltage V3 output by the power supply unit 40. A third end of the switch transistor Q1 is grounded through a capacitor C3, a third end of the switch transistor Q1 is further electrically connected to the first end of the switch transistor Q1 through the resistor R1, and the third end of the switch transistor Q1 is further electrically connected to a power pin VCC of the CAN communications chip 50. The first end of the switch transistor Q1 may serve as a control end of the switch transistor Q1. In other words, the drive signal output by the signal pin OUTC of the isolation chip 20 may be used to control the switch transistor Q1 to be turned on or off. When the drive signal output by the signal pin OUTC of the isolation chip 20 controls the switch transistor Q1 to be turned on, the voltage V3 output by the power supply unit 40 is applied to the power pin VCC of the CAN communications chip 50, that is, the power supply unit 40 supplies power to the CAN communications chip 50. When the drive signal output by the signal pin OUTC of the isolation chip 20 controls the switch transistor Q1 to be turned off, the power supply unit 40 is disconnected from the power pin VCC of the CAN communications chip 50, that is, the power supply unit 40 does not supply power to the CAN communications chip 50.

In this embodiment, a terminal resistance unit 70 includes a terminal resistor R22.

In this embodiment, the energy storage device 100a further comprises a power supply unit, the power supply unit is configured to supply power to a first switching unit, and the first switching unit may include a first switch transistor and a photo field-effect transistor, and the photo field-effect transistor may include a light emitting unit, a first switching element, and a second switching element. A first end of the first switch transistor may be connected to the controller to receive the second control signal, a second end of the first switch transistor is grounded, and the second end of the first switch transistor is electrically connected to the first end of the first switch transistor. A third end of the first switch transistor is electrically connected to a cathode of the light emitting unit, and an anode of the light emitting unit is connected to a power supply unit to receive a first voltage output by the power supply unit. A first end of the first switching element is electrically connected to a first end of the second switching element, and a second end of the first switching element is electrically connected to a second end of the second switching element. A third end of the first switching element is connected to a first end of a communications bus through a terminal resistance unit, and the third end of the first switching element is connected to a second end of the communications bus.

For example, in FIG. 5, a first switching unit 60 includes a switch transistor Q2, an optoelectronic field-effect transistor U1, and resistors R3 to R5. The switch transistor Q2 is the first switch transistor. The photo field-effect transistor U1 includes a light emitting unit, a first switching element, and a second switching element. Optionally, a resistance value of the terminal resistor R22 is 120 ohms.

A first end of the switch transistor Q2 is connected to a signal pin CAN_120R_EN of the controller 10 through the resistor R3, so as to receive a second control signal output by a first signal pin CAN_120R_EN. A second end of the switch transistor Q2 is grounded, and the second end of the switch transistor Q2 is further electrically connected to the first end of the switch transistor Q2 through the resistor R4. A third end of the switch transistor Q2 is electrically connected to a cathode of a light emitting unit of the photo field-effect transistor U1, and an anode of the light emitting unit of the photo field-effect transistor U1 is connected to the power supply unit 40 through the resistor R5, so as to receive a voltage V2 output by the power supply unit 40. The first end of the switch transistor Q2 may serve as a control end of the switch transistor Q2. In other words, the second control signal output by the signal pin CAN_120R_EN of the controller 10 may be used to control the switch transistor Q2 to be turned on or off.

In the photo field-effect transistor U1, a first end of the first switching element is electrically connected to a first end of the second switching element, a second end of the first switching element is electrically connected to a second end of the second switching element, a third end of the first switching element is connected to a CANH signal line through the terminal resistor R22, and the third end of the first switching element is connected to a CANL signal line. It may be understood that, in some other optional implementations, the photo field-effect transistor U1 may also be replaced with a switch component such as a relay.

According to the invention, the energy storage device 100a further comprises a power supply unit, the power supply unit is configured to supply power to a detection unit, and the detection unit includes a second switch transistor, a third switch transistor, a fourth switch transistor, a fifth switch transistor, a sixth switch transistor, a first resistor, and a second resistor. A first end of the sixth switch transistor is configured to receive a first control signal output by the controller, the first end of the sixth switch transistor is further electrically connected to a second end of the sixth switch transistor, and a second end of the sixth switch transistor is grounded. A third end of the sixth switch transistor is connected to a first end of the second switch transistor and a first end of the third switch transistor, and a first end of the second switch transistor is further connected to a second end of the second switch transistor and a second end of the third switch transistor. A third end of the second switch transistor is electrically connected to a power supply unit to receive a second voltage output by the power supply unit, and a third end of the third switch transistor is connected to a first end of a communications bus through the first resistor. Both a first end of the fourth switch transistor and a first end of the fifth switch transistor are configured to receive the first control signal output by the controller. A first end of the fourth switch transistor is further electrically connected to a second end of the fourth switch transistor and a second end of the fifth switch transistor. A third end of the fourth switch transistor is connected to a second end of the communications bus, and a third end of the fifth switch transistor is grounded through the second resistor.

As shown in FIG. 5, a detection unit 80 includes a switch transistor Q3, a switch transistor Q4, a switch transistor Q5, a switch transistor Q6, a switch transistor Q7, and resistors R8 to R15. The second switch transistor is the switch transistor Q3, the third switch transistor is the switch transistor Q4, the fourth switch transistor is the switch transistor Q5, the fifth switch transistor is the switch transistor Q6, the sixth switch transistor is the switch transistor Q7, the first resistor is the resistor R12, the second resistor is the resistor R15, and the communications bus may be a CANH signal line or a CANL signal line.

A first end of the switch transistor Q7 is electrically connected to a signal pin OUTC of the isolation chip 20 through the resistor R10, so as to receive a drive signal output by the signal pin OUTC. A first end of the switch transistor Q7 is further connected to a second end of the switch transistor Q7 through the resistor R11, a second end of the switch transistor Q7 is grounded, a third end of the switch transistor Q7 is connected to a first end of the switch transistor Q3 and a first end of the switch transistor Q4 through the resistor R9. The first end of the switch transistor Q3 is further connected to a second end of the switch transistor Q3 and a second end of the switch transistor Q4 through the resistor R8, and a third end of the switch transistor Q3 is electrically connected to the power supply unit 40, so as to receive the voltage V3 output by the power supply unit 40. A third end of the switch transistor Q4 is connected to the signal line CANH through the resistor R12. The first end of the switch transistor Q7 may be used as a control end of the switch transistor Q7, the first end of the switch transistor Q3 may be used as a control end of the switch transistor Q3, and the first end of the switch transistor Q4 may be used as a control end of the switch transistor Q4.

Both a first end of the switch transistor Q5 and a first end of the switch transistor Q6 are connected to the signal pin OUTC of the isolation chip 20 through the resistor R14, so as to receive the drive signal output by the signal pin OUTC. The first end of the switch transistor Q5 is further electrically connected to a second end of the switch transistor Q5 and a second end of the switch transistor Q6 through the resistor R13. A third end of the switch transistor Q5 is connected to the CANL signal line, and a third end of the switch transistor Q6 is grounded through the resistor R15. The first end of the switch transistor Q5 may be used as a control end of the switch transistor Q5, and the first end of the switch transistor Q6 may be used as a control end of the switch transistor Q6.

It may be understood that the switch transistors Q1 to Q7 may be any one of a metal-oxide-semiconductor field-effect transistor (Metal-Oxide-Semiconductor Field-Effect Transistor, MOSFET), an insulated gate bipolar transistor (Insulated Gate Bipolar Transistor, IGBT), a thyristor, a bipolar power transistor (bipolar power transistor), or a wide band semiconductor field-effect transistor.

In an optional solution, the switch transistor Q1, the switch transistor Q3, and the switch transistor Q4 are all PMOS transistors, and the switch transistor Q2, the switch transistor Q5, the switch transistor Q6, and the switch transistor Q7 are all NMOS transistors.

In this embodiment, an isolation sampling unit 90 includes an isolation operational amplifier U2 and an operational amplifier U3.

A power pin VDD1 of the isolation operational amplifier U2 receives the voltage V3 output by the power supply unit 40, and the power pin VDD1 of the isolation operational amplifier U2 is further grounded through a capacitor C6. An input pin VIN of the isolation operational amplifier U2 is electrically connected to a first end of the resistor R15 and a first end of a capacitor C5, and a pin SHDN of the isolation operational amplifier U2 is connected to a second end of the capacitor C5 and a second end of the resistor R15. The pin SHDN of the isolation operational amplifier U2 is further grounded, and a ground pin GND1 of the isolation operational amplifier U2 is grounded. A power pin VDD2 of the isolation operational amplifier U2 receives the voltage V2 output by the power supply unit 40, and the power pin VDD2 of the isolation operational amplifier U2 is further grounded through a capacitor C7. An output pin VOUT+ of the isolation operational amplifier U2 is connected to an input pin IN+ of the operational amplifier through a resistor R17, and the output pin VOUT+ of the isolation operational amplifier U2 is further grounded sequentially through the resistor R17 and a resistor R19. An output pin OUT- of the isolation operational amplifier U2 is connected to an input pin IN- of the operational amplifier U3 through a resistor R18, and a ground pin GND2 of the isolation operational amplifier U2 is grounded.

A power pin V+ of the operational amplifier U3 receives the voltage V2 output by the power supply unit 40, and the power pin V+ of the operational amplifier U3 is further connected to a power pin V- of the operational amplifier U3 through a capacitor C8. The power pin V- of the operational amplifier U3 is further connected to a connection point between an anode of a diode D1 and a cathode of a diode D2 through a capacitor C9, a cathode of the diode D1 receives the voltage V2 output by the power supply unit 40, and an anode of the diode D2 is grounded. An output pin OUT of the operational amplifier U3 is connected to an input pin IN of the operational amplifier U3 through a resistor R20, and an output pin OUT of the operational amplifier U3 is electrically connected to the connection point between the anode of the diode D1 and the cathode of the diode D2 through a resistor R21. The output pin OUT of the operational amplifier U3 is further electrically connected to a third signal pin V1 of the controller 10 through a resistor R21, so as to output a voltage signal obtained after isolation sampling to the third signal pin V1 of the controller 10.

In this embodiment, in a case that a resistance value of a terminal resistor on a communications bus is greater than a first threshold, the controller may determine that the communications bus is required to be connected to a terminal resistance unit, and output a second control signal in a first level state to a first switching unit, so as to control the first switching unit to be turned on.

In this embodiment, in a case that a resistance value of a terminal resistor on a communications bus is greater than a second threshold and less than a first threshold, the controller may determine that the communications bus is required to be connected to a terminal resistance unit, and output a second control signal in a first level state to a first switching unit, so as to control the first switching unit to be turned on.

In this embodiment, if a resistance value of a terminal resistor on a communications bus is greater than a third threshold and less than or equal to a second threshold, the controller may determine that a communications bus is required to be disconnected from a terminal resistance unit, and output a second control signal in a second level state to a first switching unit, so as to control the first switching unit to be turned off.

In this embodiment, when the controller outputs the first control signal in the first level state, the first control signal is used for controlling a sixth switch transistor to be turned on, controlling a second switch transistor to be turned on, controlling a third switch transistor to be turned on, controlling a fourth switch transistor to be turned on, and controlling a fifth switch transistor to be turned on. Thus, the controller may be configured to: collect a voltage across a second resistor, and determine the resistance value of the terminal resistor on the communications bus based on the voltage across the second resistor, a second voltage output by a power supply unit, a resistance value of a first resistor, and a resistance value of the second resistor.

The following uses the circuit diagram of the energy storage device 100a in the embodiment illustrated in FIG. 5 as an example to describe in detail a working principle of the energy storage device in the present application. As shown in FIG. 5, the detection unit 80 includes a switch transistor Q3, a switch transistor Q4, a switch transistor Q5, a switch transistor Q6, a switch transistor Q7, and resistors R8 to R15. The second switch transistor is the switch transistor Q3, the third switch transistor is the switch transistor Q4, the fourth switch transistor is the switch transistor Q5, the fifth switch transistor is the switch transistor Q6, the sixth switch transistor is the switch transistor Q7, the first resistor is the resistor R12, the second resistor is the resistor R15, and the communications bus may be a CANH signal line or a CANL signal line.

When the energy storage system 200 detects a terminal resistor, a first signal pin MCU_CAN_RESZJ of the controller 10 outputs a high-level first control signal to a signal pin INC of the isolation chip 20. After performing isolation processing on the high-level first control signal, the isolation chip 20 outputs, via a signal pin OUTC, a high-level drive signal to a first end of the switch transistor Q1, a first end of the switch transistor Q7, a first end of the switch transistor Q5, and a first end of the switch transistor Q6, so as to control the switch transistor Q1 to be turned off, the switch transistor Q5 to be turned on, the switch transistor Q6 to be turned on, and the switch transistor Q7 to be turned on. The isolation chip 20 controls the switch transistor Q1 to be turned off, so that the power supply unit 40 is disconnected from the CAN communications chip 50, and the power supply unit 40 does not supply power to the CAN communications chip 50. In this case, the CAN communications chip 50 does not communicate with any other energy storage device (for example, the energy storage device 100b or the energy storage device 100c), and the CAN communications chip 50 does not affect detection of a terminal resistor on the CAN bus. The isolation chip 20 controls the switch transistor Q7 to be turned off, so that both the switch transistor Q3 and the switch transistor Q4 are turned on. After the switch transistor Q3, the switch transistor Q4, the switch transistor Q5, and the switch transistor Q6, the resistor R12, a terminal resistor R16, and the resistor R15 are connected in series. The terminal resistor R16 is a to-be-detected terminal resistor, and the terminal resistor R16 may also be considered as a terminal resistor on the communications bus, that is, a terminal resistor on the CAN bus.

The isolation operational amplifier U2 is connected to two ends of the resistor R15, that is, the isolation operational amplifier U2 samples a voltage signal at two ends of the resistor R15, and transmits the voltage sampled at two ends of the resistor R15 to a third pin V1 of the controller 10 after performing isolation processing. It may be understood that the voltage signal is the detection signal mentioned in the embodiment illustrated in FIG. 2, and the controller 10 calculates a detected resistance value of the terminal resistor R16 based on a voltage at two ends of the resistor R15. The detection unit 80 may determine a quantity of terminal resistors on the CAN bus based on the resistance value of the terminal resistor R16.

The resistance value of the terminal resistor R16 may be calculated according to the formula (1) as follows: $r 16 = \frac{V 3 \times r 15}{V 1} - r 15 - r 12$
where r16 denotes a resistance value of the terminal resistor R16, r15 denotes a resistance value of the resistor R15, r12 denotes a resistance value of the resistor R12, V1 denotes a voltage across both ends of the resistor R15, and V3 denotes a voltage output by the power supply unit 40.

If the resistance value *r*16 of the terminal resistor R16 is greater than a first threshold, the controller 10 may determine that no terminal resistor is connected to the CAN bus. The controller 10 outputs a high-level second control signal to a switch transistor Q2, to control the switch transistor Q2 to be turned on, so that a light emitting unit of an photo field-effect transistor U1 is illuminated. Both a first switching element and a second switching element are turned on, and two ends of a terminal resistor R22 are respectively connected to the CANH signal line and the CANL signal line. That is, the controller 10 controls a first switching unit 60 to be turned on, so as to control the terminal resistor R22 to be connected to the CAN bus.

If the resistance value r16 of the terminal resistor R16 is greater than a second threshold and less than a first threshold, the controller 10 may determine that one terminal resistor has been connected to the CAN bus. The controller 10 outputs a high-level second control signal to a switch transistor Q2, to control the switch transistor Q2 to be turned on, so that a light emitting unit of an photo field-effect transistor U1 is illuminated. Both a first switching element and a second switching element are turned on, and two ends of a terminal resistor R22 are respectively connected to the CANH signal line and the CANL signal line. That is, the controller 10 controls a first switching unit 60 to be turned on, so as to control the terminal resistor R22 to be connected to the CAN bus.

If the resistance value r16 of the terminal resistor R16 is greater than a third threshold and less than or equal to a second threshold, the controller 10 may determine that two terminal resistors have been connected to the CAN bus. The controller 10 outputs a low-level second control signal to a first end of the switch transistor Q2, to control the switch transistor Q2 to be turned off, so that a light emitting unit of the photo field-effect transistor U1 is not illuminated. Both a first switching element and a second switching element are turned off, and the terminal resistor R22 is disconnected from the CANH signal line and the CANL signal line. That is, the controller 10 controls the first switching unit 60 to be turned off, so as to control the terminal resistor R22 not to be connected to the CAN bus.

In an optional implementation, the first threshold may be 150 ohms, the second threshold may be 90 ohms, and the third threshold may be 30 ohms.

When the energy storage system 200 does not detect the terminal resistor on the CAN bus, the controller 10 outputs a low-level first control signal to the signal pin INC of the isolation chip 20. After performing isolation processing on the low-level first control signal, the isolation chip 20 outputs a low-level drive signal to the first end of the switch transistor Q1 via the signal pin OUTC, so as to control the switch transistor Q1 to be turned on, so that a voltage V3 output by the power supply unit 40 supplies power to the CAN communications chip 50. The CAN communications chip 50 may communicate with another energy storage device (for example, the energy storage device 100b and the energy storage device 100c) via the CAN bus. The signal pin OUTC of the isolation chip 20 further outputs the low-level drive signal to a first end of the switch transistor Q7, a first end of the switch transistor Q5, and a first end of the switch transistor Q6, so as to respectively control the switch transistor Q5 to be turned off, the switch transistor Q6 to be turned off, and the switch transistor Q7 to be turned off.

It may be understood that a structure of the another energy storage device (for example, the energy storage device 100b and the energy storage device 100c) in the energy storage system 200 is the same as that of the energy storage device 100a. Therefore, for example, a working principle of the energy storage device 100b and a working principle of the energy storage device 100c are the same as a working principle of the energy storage device 100, and details are not described herein again.

According to the energy storage device and the energy storage system in the present application, a quantity of terminal resistors connected to another energy storage device on a CAN bus is detected by a detection unit, and then whether to allow a terminal resistor to be connected is determined based on the detected quantity of terminal resistors. This may solve problems in a conventional technology that a quantity of terminal resistors on a CAN bus is required to be manually detected and a terminal resistor on a CAN bus is required to be manually configured.

For those skilled in the art, it is apparent that the present application is not limited to the details of the foregoing exemplary embodiments, and can be implemented in other specific forms without departing from the basic features of the present application. The scope of protection is defined by the appended set of claims.

## Claims

1. An energy storage device (100a), communicatively connectable to a communications bus in an energy storage system, wherein the energy storage device (100a) comprises a terminal resistance unit (70), a first switching unit (60), a detection unit (80), and a controller (10);
the terminal resistance unit (70) and the first switching unit (60) are configured to be successively connected in series to the communications bus;
the detection unit (80) is configured to be connected to the communications bus, and the detection unit (80) is configured to: in response to a first control signal from the controller (10), detect a terminal resistor on the communications bus, to output a detection signal to the controller (10); and
the controller (10) is connected to the first switching unit (60), and the controller (10) is configured to: in response to the detection signal from the detection unit (80), determine whether the communications bus is required to be connected to or disconnected from the terminal resistance unit (70), and correspondingly control the first switching unit (60) to be turned on or turned off,
wherein the energy storage device (100a) further comprises a power supply unit (40), the power supply unit (40) is configured to supply power to the detection unit (80), the detection unit (80) comprises a second switch transistor (Q3), a third switch transistor (Q4), a fourth switch transistor (Q5), fifth switch transistor (Q6), a sixth switch transistor (Q7), a first resistor (R12), and a second resistor (R15);
a first end of the sixth switch transistor is configured to receive the first control signal output by the controller (10), the first end of the sixth switch transistor is further electrically connected to a second end of the sixth switch transistor, a second end of the sixth switch transistor is grounded, a third end of the sixth switch transistor is connected to a first end of the second switch transistor and a first end of the third switch transistor, a first end of the second switch transistor is further connected to a second end of the second switch transistor and a second end of the third switch transistor, a third end of the second switch transistor is electrically connected to the power supply unit (40) to receive a second voltage output by the power supply unit (40), and a third end of the third switch transistor is configured to be connected to a first end of the communications bus through the first resistor; and
both a first end of the fourth switch transistor and a first end of the fifth switch transistor are configured to receive the first control signal output by the controller (10), a first end of the fourth switch transistor is further electrically connected to a second end of the fourth switch transistor and a second end of the fifth switch transistor, a third end of the fourth switch transistor is configured to be connected to a second end of the communications bus, and a third end of the fifth switch transistor is grounded through the second resistor.

2. The energy storage device (100a) according to claim 1, wherein the controller (10) is further configured to:
in response to the detection signal from the detection unit (80), determine a resistance value of the terminal resistor on the communications bus.

3. The energy storage device (100a) according to claim 2, wherein the controller (10) is further configured to:
in a case that the resistance value of the terminal resistor on the communications bus is greater than a first threshold, determine that the communications bus is required to be connected to the terminal resistance unit (70), and output a second control signal in a first level state to the first switching unit (60), to control the first switching unit (60) to be turned on.

4. The energy storage device (100a) according to claim 2, wherein the controller (10) is further configured to:
in a case that the resistance value of the terminal resistor on the communications bus is greater than a second threshold and less than a first threshold, determine that the communications bus is required to be connected to the terminal resistance unit (70), and output a second control signal in a first level state to the first switching unit (60), to control the first switching unit (60) to be turned on.

5. The energy storage device (100a) according to claim 2, wherein the controller (10) is further configured to:
in a case that the resistance value of the terminal resistor on the communications bus is greater than a third threshold and less than or equal to a second threshold, determine that the communications bus is required to be disconnected from the terminal resistance unit (70), and output a second control signal in a second level state to the first switching unit (60), to control the first switching unit (60) to be turned off.

6. The energy storage device (100a) according to claim 1, wherein the energy storage device (100a) further comprises a second switching unit (30) and a controller area network CAN communications chip (50);
the CAN communications chip (50) is connected to the communications bus, and is communicatively connected to another energy storage device in the energy storage system via the communications bus;
the power supply unit (40) is configured to supply power to the CAN communications chip (50); and
the second switching unit (30) is connected between the power supply unit (40) and the CAN communications chip (50), and the second switching unit (30) is configured to: in response to the first control signal from the controller (10), enable the power supply unit (40) and the CAN communications chip (50) to be electrically connected or disconnected.

7. The energy storage device (100a) according to claim 1, wherein the power supply unit (40) is configured to supply power to the first switching unit (60), the first switching unit (60) comprises a first switch transistor and a photo field-effect transistor, the photo field-effect transistor comprises a light emitting unit, a first switching element, and a second switching element, a first end of the first switch transistor is connected to the controller (10) to receive a second control signal, a second end of the first switch transistor is grounded, the second end of the first switch transistor is electrically connected to the first end of the first switch transistor, a third end of the first switch transistor is electrically connected to a cathode of the light emitting unit, an anode of the light emitting unit is connected to the power supply unit (40) to receive a first voltage output by the power supply unit (40), a first end of the first switching element is electrically connected to a first end of the second switching element, and a second end of the first switching element is electrically connected to a second end of the second switching element, a third end of the first switching element is configured to be connected to a first end of the communications bus through the terminal resistance unit (70), and the third end of the first switching element is configured to be connected to a second end of the communications bus.

8. The energy storage device (100a) according to claim 1, wherein
when the controller (10) outputs the first control signal in a first level state, the first control signal is used for: controlling the sixth switch transistor to be turned on, controlling the second switch transistor to be turned on, controlling the third switch transistor to be turned on, controlling the fourth switch transistor to be turned on, and controlling the fifth switch transistor to be turned on; and the controller (10) is configured to: collect a voltage across the second resistor, and determine a resistance value of the terminal resistor on the communications bus based on the voltage across the second resistor, the second voltage output by the power supply unit, a resistance value of the first resistor, and a resistance value of the second resistor.

9. An energy storage system comprising a communications bus, **characterized in that** the energy storage system comprises at least two energy storage devices according to any one of claims 1 to 8, and the at least two energy storage devices are communicatively connected via the communications bus.

## Patentansprüche

1. Energiespeichervorrichtung (100a), die kommunikativ mit einem Kommunikationsbus in einem Energiespeichersystem verbindbar ist, wobei die Energiespeichervorrichtung (100a) eine Abschlusswiderstandseinheit (70), eine erste Schalteinheit (60), eine Detektionseinheit (80) und eine Steuerung (10) umfasst;
die Abschlusswiderstandseinheit (70) und die erste Schalteinheit (60) dazu eingerichtet sind, nacheinander in Reihe mit dem Kommunikationsbus verbunden zu werden;
die Detektionseinheit (80) dazu eingerichtet ist, mit dem Kommunikationsbus verbunden zu werden, und die Detektionseinheit (80) dazu eingerichtet ist: als Reaktion auf ein erstes Steuersignal von der Steuerung (10) einen Abschlusswiderstand am Kommunikationsbus zu detektieren, um ein Detektionssignal an die Steuerung (10) auszugeben; und
die Steuerung (10) mit der ersten Schalteinheit (60) verbunden ist, und die Steuerung (10) dazu eingerichtet ist: als Reaktion auf das Detektionssignal von der Detektionseinheit (80) zu bestimmen, ob der Kommunikationsbus mit der Abschlusswiderstandseinheit (70) zu verbinden oder von dieser zu trennen ist, und die erste Schalteinheit (60) entsprechend so zu steuern, dass sie eingeschaltet oder ausgeschaltet wird,
wobei die Energiespeichervorrichtung (100a) ferner eine Stromversorgungseinheit (40) umfasst, die Stromversorgungseinheit (40) dazu eingerichtet ist, die Detektionseinheit (80) mit Strom zu versorgen, die Detektionseinheit (80) einen zweiten Schalttransistor (Q3), einen dritten Schalttransistor (Q4), einen vierten Schalttransistor (Q5), einen fünften Schalttransistor (Q6), einen sechsten Schalttransistor (Q7), einen ersten Widerstand (R12) und einen zweiten Widerstand (R15) umfasst;
ein erstes Ende des sechsten Schalttransistors dazu eingerichtet ist, das von der Steuerung (10) ausgegebene erste Steuersignal zu empfangen, das erste Ende des sechsten Schalttransistors ferner elektrisch mit einem zweiten Ende des sechsten Schalttransistors verbunden ist, ein zweites Ende des sechsten Schalttransistors geerdet ist, ein drittes Ende des sechsten Schalttransistors mit einem ersten Ende des zweiten Schalttransistors und einem ersten Ende des dritten Schalttransistors verbunden ist, ein erstes Ende des zweiten Schalttransistors ferner mit einem zweiten Ende des zweiten Schalttransistors und einem zweiten Ende des dritten Schalttransistors verbunden ist, ein drittes Ende des zweiten Schalttransistors elektrisch mit der Stromversorgungseinheit (40) verbunden ist, um eine von der Stromversorgungseinheit (40) ausgegebene zweite Spannung zu empfangen, und ein drittes Ende des dritten Schalttransistors dazu eingerichtet ist, über den ersten Widerstand mit einem ersten Ende des Kommunikationsbusses verbunden zu werden; und
sowohl ein erstes Ende des vierten Schalttransistors als auch ein erstes Ende des fünften Schalttransistors dazu eingerichtet sind, das von der Steuerung (10) ausgegebene erste Steuersignal zu empfangen, ein erstes Ende des vierten Schalttransistors ferner elektrisch mit einem zweiten Ende des vierten Schalttransistors und einem zweiten Ende des fünften Schalttransistors verbunden ist, ein drittes Ende des vierten Schalttransistors dazu eingerichtet ist, mit einem zweiten Ende des Kommunikationsbusses verbunden zu werden, und ein drittes Ende des fünften Schalttransistors über den zweiten Widerstand geerdet ist.

2. Energiespeichervorrichtung (100a) nach Anspruch 1, wobei die Steuerung (10) ferner dazu eingerichtet ist:
als Reaktion auf das Detektionssignal von der Detektionseinheit (80) einen Widerstandswert des Abschlusswiderstands am Kommunikationsbus zu bestimmen.

3. Energiespeichervorrichtung (100a) nach Anspruch 2, wobei die Steuerung (10) ferner dazu eingerichtet ist:
in einem Fall, in dem der Widerstandswert des Abschlusswiderstands am Kommunikationsbus größer als ein erster Schwellenwert ist, zu bestimmen, dass der Kommunikationsbus mit der Abschlusswiderstandseinheit (70) zu verbinden ist, und ein zweites Steuersignal in einem ersten Pegelzustand an die erste Schalteinheit (60) auszugeben, um die erste Schalteinheit (60) so zu steuern, dass sie eingeschaltet wird.

4. Energiespeichervorrichtung (100a) nach Anspruch 2, wobei die Steuerung (10) ferner dazu eingerichtet ist:
in einem Fall, in dem der Widerstandswert des Abschlusswiderstands am Kommunikationsbus größer als ein zweiter Schwellenwert und kleiner als ein erster Schwellenwert ist, zu bestimmen, dass der Kommunikationsbus mit der Abschlusswiderstandseinheit (70) zu verbinden ist, und ein zweites Steuersignal in einem ersten Pegelzustand an die erste Schalteinheit (60) auszugeben, um die erste Schalteinheit (60) so zu steuern, dass sie eingeschaltet wird.

5. Energiespeichervorrichtung (100a) nach Anspruch 2, wobei die Steuerung (10) ferner dazu eingerichtet ist:
in einem Fall, in dem der Widerstandswert des Abschlusswiderstands am Kommunikationsbus größer als ein dritter Schwellenwert und kleiner als oder gleich einem zweiten Schwellenwert ist, zu bestimmen, dass der Kommunikationsbus von der Abschlusswiderstandseinheit (70) zu trennen ist, und ein zweites Steuersignal in einem zweiten Pegelzustand an die erste Schalteinheit (60) auszugeben, um die erste Schalteinheit (60) so zu steuern, dass sie ausgeschaltet wird.

6. Energiespeichervorrichtung (100a) nach Anspruch 1, wobei die Energiespeichervorrichtung (100a) ferner eine zweite Schalteinheit (30) und einen Controller-Area-Network(CAN)-Kommunikationschip (50) umfasst;
der CAN-Kommunikationschip (50) mit dem Kommunikationsbus verbunden ist und über den Kommunikationsbus kommunikativ mit einer weiteren Energiespeichervorrichtung in dem Energiespeichersystem verbunden ist;
die Stromversorgungseinheit (40) dazu eingerichtet ist, den CAN-Kommunikationschip (50) mit Strom zu versorgen; und
die zweite Schalteinheit (30) zwischen der Stromversorgungseinheit (40) und dem CAN-Kommunikationschip (50) verbunden ist, und die zweite Schalteinheit (30) dazu eingerichtet ist: als Reaktion auf das erste Steuersignal von der Steuerung (10) zu ermöglichen, dass die Stromversorgungseinheit (40) und der CAN-Kommunikationschip (50) elektrisch verbunden oder voneinander getrennt werden.

7. Energiespeichervorrichtung (100a) nach Anspruch 1, wobei die Stromversorgungseinheit (40) dazu eingerichtet ist, die erste Schalteinheit (60) mit Strom zu versorgen, die erste Schalteinheit (60) einen ersten Schalttransistor und einen Photo-Feldeffekttransistor umfasst, der Photo-Feldeffekttransistor eine Lichtemissionseinheit, ein erstes Schaltelement und ein zweites Schaltelement umfasst, ein erstes Ende des ersten Schalttransistors mit der Steuerung (10) verbunden ist, um ein zweites Steuersignal zu empfangen, ein zweites Ende des ersten Schalttransistors geerdet ist, das zweite Ende des ersten Schalttransistors elektrisch mit dem ersten Ende des ersten Schalttransistors verbunden ist, ein drittes Ende des ersten Schalttransistors elektrisch mit einer Kathode der Lichtemissionseinheit verbunden ist, eine Anode der Lichtemissionseinheit mit der Stromversorgungseinheit (40) verbunden ist, um eine von der Stromversorgungseinheit (40) ausgegebene erste Spannung zu empfangen, ein erstes Ende des ersten Schaltelements elektrisch mit einem ersten Ende des zweiten Schaltelements verbunden ist und ein zweites Ende des ersten Schaltelements elektrisch mit einem zweiten Ende des zweiten Schaltelements verbunden ist, ein drittes Ende des ersten Schaltelements dazu eingerichtet ist, über die Abschlusswiderstandseinheit (70) mit einem ersten Ende des Kommunikationsbusses verbunden zu werden, und das dritte Ende des ersten Schaltelements dazu eingerichtet ist, mit einem zweiten Ende des Kommunikationsbusses verbunden zu werden.

8. Energiespeichervorrichtung (100a) nach Anspruch 1, wobei,
wenn die Steuerung (10) das erste Steuersignal in einem ersten Pegelzustand ausgibt, das erste Steuersignal für Folgendes verwendet wird: Steuern des sechsten Schalttransistors, so dass er eingeschaltet wird, Steuern des zweiten Schalttransistors, so dass er eingeschaltet wird, Steuern des dritten Schalttransistors, so dass er eingeschaltet wird, Steuern des vierten Schalttransistors, so dass er eingeschaltet wird, und Steuern des fünften Schalttransistors, so dass er eingeschaltet wird; und die Steuerung (10) für Folgendes eingerichtet ist: Erfassen einer Spannung am zweiten Widerstand und Bestimmen eines Widerstandswerts des Abschlusswiderstands am Kommunikationsbus basierend auf der Spannung am zweiten Widerstand, der von der Stromversorgungseinheit ausgegebenen zweiten Spannung, einem Widerstandswert des ersten Widerstands und einem Widerstandswert des zweiten Widerstands.

9. Energiespeichersystem, umfassend einen Kommunikationsbus, **dadurch gekennzeichnet, dass** das Energiespeichersystem mindestens zwei Energiespeichervorrichtungen nach einem der Ansprüche 1 bis 8 umfasst und die mindestens zwei Energiespeichervorrichtungen über den Kommunikationsbus kommunikativ verbunden sind.

## Revendications

1. Dispositif de stockage d'énergie (100a), pouvant être connecté en communication à un bus de communication dans un système de stockage d'énergie, dans lequel le dispositif de stockage d'énergie (100a) comprend une unité de résistance de terminaison (70), une première unité de commutation (60), une unité de détection (80) et un dispositif de commande (10) ;
l'unité de résistance de terminaison (70) et la première unité de commutation (60) sont configurées pour être connectées successivement en série au bus de communication ;
l'unité de détection (80) est configurée pour être connectée au bus de communication, et l'unité de détection (80) est configurée pour : en réponse à un premier signal de commande provenant du dispositif de commande (10), détecter une résistance de terminaison sur le bus de communication, afin de fournir en sortie un signal de détection au dispositif de commande (10) ; et
le dispositif de commande (10) est connecté à la première unité de commutation (60), et le dispositif de commande (10) est configuré pour : en réponse au signal de détection provenant de l'unité de détection (80), déterminer si le bus de communication doit être connecté à l'unité de résistance de terminaison (70) ou déconnecté de celle-ci, et commander en conséquence l'activation ou la désactivation de la première unité de commutation (60),
dans lequel le dispositif de stockage d'énergie (100a) comprend en outre une unité d'alimentation électrique (40), l'unité d'alimentation électrique (40) est configurée pour alimenter en électricité l'unité de détection (80), l'unité de détection (80) comprend un deuxième transistor de commutation (Q3), un troisième transistor de commutation (Q4), un quatrième transistor de commutation (Q5), un cinquième transistor de commutation (Q6), un sixième transistor de commutation (Q7), une première résistance (R12) et une deuxième résistance (R15) ;
une première extrémité du sixième transistor de commutation est configurée pour recevoir le premier signal de commande fourni en sortie par le dispositif de commande (10), la première extrémité du sixième transistor de commutation est en outre électriquement connectée à une deuxième extrémité du sixième transistor de commutation, une deuxième extrémité du sixième transistor de commutation est mise à la masse, une troisième extrémité du sixième transistor de commutation est connectée à une première extrémité du deuxième transistor de commutation et à une première extrémité du troisième transistor de commutation, une première extrémité du deuxième transistor de commutation est en outre connectée à une deuxième extrémité du deuxième transistor de commutation et à une deuxième extrémité du troisième transistor de commutation, une troisième extrémité du deuxième transistor de commutation est électriquement connectée à l'unité d'alimentation électrique (40) pour recevoir une deuxième tension fournie en sortie par l'unité d'alimentation électrique (40), et une troisième extrémité du troisième transistor de commutation est configurée pour être connectée à une première extrémité du bus de communication par la première résistance ; et
une première extrémité du quatrième transistor de commutation et une première extrémité du cinquième transistor de commutation sont toutes deux configurées pour recevoir le premier signal de commande fourni en sortie par le dispositif de commande (10), une première extrémité du quatrième transistor de commutation est en outre électriquement connectée à une deuxième extrémité du quatrième transistor de commutation et à une deuxième extrémité du cinquième transistor de commutation, une troisième extrémité du quatrième transistor de commutation est configurée pour être connectée à une deuxième extrémité du bus de communication, et une troisième extrémité du cinquième transistor de commutation est mise à la masse par la deuxième résistance.

2. Dispositif de stockage d'énergie (100a) selon la revendication 1, dans lequel le dispositif de commande (10) est en outre configuré pour :
en réponse au signal de détection provenant de l'unité de détection (80), déterminer une valeur de résistance de la résistance de terminaison sur le bus de communication.

3. Dispositif de stockage d'énergie (100a) selon la revendication 2, dans lequel le dispositif de commande (10) est en outre configuré pour :
dans le cas où la valeur de résistance de la résistance de terminaison sur le bus de communication est supérieure à un premier seuil, déterminer que le bus de communication doit être connecté à l'unité de résistance de terminaison (70), et fournir en sortie un deuxième signal de commande dans un état de premier niveau vers la première unité de commutation (60), afin de commander l'activation de la première unité de commutation (60).

4. Dispositif de stockage d'énergie (100a) selon la revendication 2, dans lequel le dispositif de commande (10) est en outre configuré pour :
dans le cas où la valeur de résistance de la résistance de terminaison sur le bus de communication est supérieure à un deuxième seuil et inférieure à un premier seuil, déterminer que le bus de communication doit être connecté à l'unité de résistance de terminaison (70), et fournir en sortie un deuxième signal de commande dans un état de premier niveau vers la première unité de commutation (60), afin de commander l'activation de la première unité de commutation (60).

5. Dispositif de stockage d'énergie (100a) selon la revendication 2, dans lequel le dispositif de commande (10) est en outre configuré pour :
dans le cas où la valeur de résistance de la résistance de terminaison sur le bus de communication est supérieure à un troisième seuil et inférieure ou égale à un deuxième seuil, déterminer que le bus de communication doit être déconnecté de l'unité de résistance de terminaison (70), et fournir en sortie un deuxième signal de commande dans un état de deuxième niveau vers la première unité de commutation (60), pour commander la désactivation de la première unité de commutation (60).

6. Dispositif de stockage d'énergie (100a) selon la revendication 1, dans lequel le dispositif de stockage d'énergie (100a) comprend en outre une deuxième unité de commutation (30) et une puce de communication de type Controller Area Network (CAN) (50) ;
la puce de communication CAN (50) est connectée au bus de communication et est connectée en communication à un autre dispositif de stockage d'énergie dans le système de stockage d'énergie par l'intermédiaire du bus de communication ;
l'unité d'alimentation électrique (40) est configurée pour alimenter en électricité la puce de communication CAN (50) ; et
la deuxième unité de commutation (30) est connectée entre l'unité d'alimentation électrique (40) et la puce de communication CAN (50), et la deuxième unité de commutation (30) est configurée pour : en réponse au premier signal de commande provenant du dispositif de commande (10), permettre à l'unité d'alimentation électrique (40) et à la puce de communication CAN (50) d'être électriquement connectées l'une à l'autre ou déconnectées l'une de l'autre.

7. Dispositif de stockage d'énergie (100a) selon la revendication 1, dans lequel l'unité d'alimentation électrique (40) est configurée pour alimenter la première unité de commutation (60), la première unité de commutation (60) comprend un premier transistor de commutation et un phototransistor à effet de champ, le phototransistor à effet de champ comprend une unité émettrice de lumière, un premier élément de commutation et un deuxième élément de commutation, une première extrémité du premier transistor de commutation est connectée au dispositif de commande (10) pour recevoir un deuxième signal de commande, une deuxième extrémité du premier transistor de commutation est mise à la masse, la deuxième extrémité du premier transistor de commutation est électriquement connectée à la première extrémité du premier transistor de commutation, une troisième extrémité du premier transistor de commutation est électriquement connectée à une cathode de l'unité émettrice de lumière, une anode de l'unité émettrice de lumière est connectée à l'unité d'alimentation électrique (40) pour recevoir une première tension fournie en sortie par l'unité d'alimentation électrique (40), une première extrémité du premier élément de commutation est électriquement connectée à une première extrémité du deuxième élément de commutation, et une deuxième extrémité du premier élément de commutation est électriquement connectée à une deuxième extrémité du deuxième élément de commutation, une troisième extrémité du premier élément de commutation est configurée pour être connectée à une première extrémité du bus de communication par l'unité de résistance de terminaison (70), et la troisième extrémité du premier élément de commutation est configurée pour être connectée à une deuxième extrémité du bus de communication.

8. Dispositif de stockage d'énergie (100a) selon la revendication 1, dans lequel
lorsque le dispositif de commande (10) fournit en sortie le premier signal de commande dans un état de premier niveau, le premier signal de commande est utilisé pour : commander l'activation du sixième transistor de commutation, commander l'activation du deuxième transistor de commutation, commander l'activation du troisième transistor de commutation, commander l'activation du quatrième transistor de commutation, et commander l'activation du cinquième transistor de commutation ; et le dispositif de commande (10) est configuré pour : collecter une tension aux bornes de la deuxième résistance, et déterminer une valeur de résistance de la résistance de terminaison sur le bus de communication sur la base de la tension aux bornes de la deuxième résistance, de la deuxième tension fournie en sortie par l'unité d'alimentation électrique, d'une valeur de résistance de la première résistance et d'une valeur de résistance de la deuxième résistance.

9. Système de stockage d'énergie comprenant un bus de communication, **caractérisé en ce que** le système de stockage d'énergie comprend au moins deux dispositifs de stockage d'énergie selon l'une quelconque des revendications 1 à 8, et les au moins deux dispositifs de stockage d'énergie sont connectés en communication par l'intermédiaire du bus de communication.
